# EUROPÄISCHE PATENTSCHRIFT

(11) **EP 0 491 980 B1**
(45) Veröffentlichungstag und Bekanntmachung des Hinweises auf die Patenterteilung: **09.10.1996**
(21) Anmeldenummer: 90125348.4
(22) Anmeldetag: 22.12.1990
(51) Int. Cl.: H03F 1/02, H03F 1/52, H03F 3/45

(54) **Spannungsregler mit einem CMOS-Transkonduktanzverstärker mit gleitendem Arbeitspunkt**
Voltage regulator including CMOS transconductance amplifier with dynamic biasing
Regulateur de tension avec amplificateur CMOS de transconductance avec polarisation glissante

(43) Veröffentlichungstag der Anmeldung: 01.07.1992
(73) Patentinhaber: Deutsche ITT Industries GmbH, 79108 Freiburg (DE)
(72) Erfinder: Theus, Ulrich, Dr., W-7803 Gundelfingen (DE)

(56) Entgegenhaltungen:
- US-A- 4 355 341
- US-A- 4 859 963
- US-A- 4 897 612
- IEEE JOURNAL OF SOLID-STATE CIRCUITS. vol. 25, no. 3, Juni 1990, NEW YORK US Seiten 684 - 691; L.G.A. Callewaert et al.: "Class AB CMOS Amplifiers with High Efficiency"
- Tsividis Y. & Antognetti P.: "Design of MOS VLSI Circuits for Telecommunications" 1985, US ENGLEWOOD CLIFFS, PRENTICE HALL, US
- U. TIETZE CH. SCHENK: "HALBLEITER-SCHALTUNGSTECHNIK" 1980, Springer-Verlag Berlin DE, Germany

## Beschreibung

Die Erfindung betrifft einen Spannungsregler, der im Regelkreis als verstärkendes Element einen CMOS-Transkonduktanzverstärker mit gleitendem Arbeitspunkt enthält, vgl. den Oberbegriff des Anspruchs 1.

Derartige Transkonduktanzverstärker mit möglichst hoher Steilheit werden auch als "Operational-Transkonduktanzverstärker" bezeichnet. Sie werden als verstärkende Elemente - wobei die Verstärkung möglichst hoch sein muß - für Filter mit geschalteten Kapazitäten verwendet. Durch die hohe Steilheit soll der jeweilige Ladungszustand dieser Kapazitäten möglichst rasch auf einen neuen Ladungszustand gebracht werden. Die Stabilität dieser Schaltung wird dabei durch die Lastkapazität selbst sichergestellt.

Ein Nachteil bei üblichen, monolithisch integrierten CMOS-Transkonduktanzverstärkern ist die relativ geringe Steilheit der MOS-Transistoren. Ein weiterer Nachteil ergibt sich, wenn dabei MOS-Transistoren als Source-Folger verwendet werden - dies ist eine Folge des relativ hohen Innenwiderstandes dieser Source-Folger. Bei der großen Variation des Laststromes, die sich aus der Kondensatorumladung ergibt, geht ferner im Großsignalbetrieb die quadratische Strom-Spannungskennlinie in den Umladevorgang mit ein, wodurch Verzerrungen mit geradem Oberwellenanteil erzeugt werden. Ein vergleichbarer CMOS-Transkonduktanzverstärker ist beispielsweise in IEEE Journal of Solid State Circuits, Bd. 25, Nr. 3, Juni 1990, S. 684 - 691, Titel "Class AB CMOS Amplifiers with High Efficiency" beschrieben, vgl. dort insbesondere Fig. 5 auf Seite 687.

Es ist daher Aufgabe der im Anspruch 1 gekennzeichneten Erfindung, für einen Spannungsregler einen CMOS-Transkonduktanzverstärker mit gleitendem Arbeitspunkt bereitzustellen, der trotz einer geringen Ruhestromaufnahme eine hohe Stromergiebigkeit des Ausgangs und damit eine möglichst große Steilheit in sich vereint. Dabei dient der Spannungsregler zur Speisung einer monolithisch mitintegrierten CMOS-Schaltung. Die Chipfläche ist dabei im wesentlichen durch die CMOS-Schaltung belegt, die insbesondere aus digital arbeitenden Zellen besteht, die bei der Auslegung einer Zellenbibliothek entnehmbar sind.

Eine weitere Aufgabe der Erfindung ist es, die Spannungsreglerschaltung auf dem Chip so auszubilden, daß sie ohne zusätzliche externe Siebmittel auskommt. Dadurch können externe Anschlußkontakte eingespart werden.

Die Erfindung und weitere Vorteile werden nun anhand der Figuren der Zeichnung näher erläutert:
Fig. 1 zeigt schematisch als Schaltbild ein Ausführungsbeispiel des in wesentlichen Teilen bekannten CMOS-Transkonduktanzverstärkers und
Fig. 2 zeigt schematisch als Blockschaltbild einen auf dem Chip mitintegrierten Spannungsregler für eine CMOS-Logik-Schaltung.

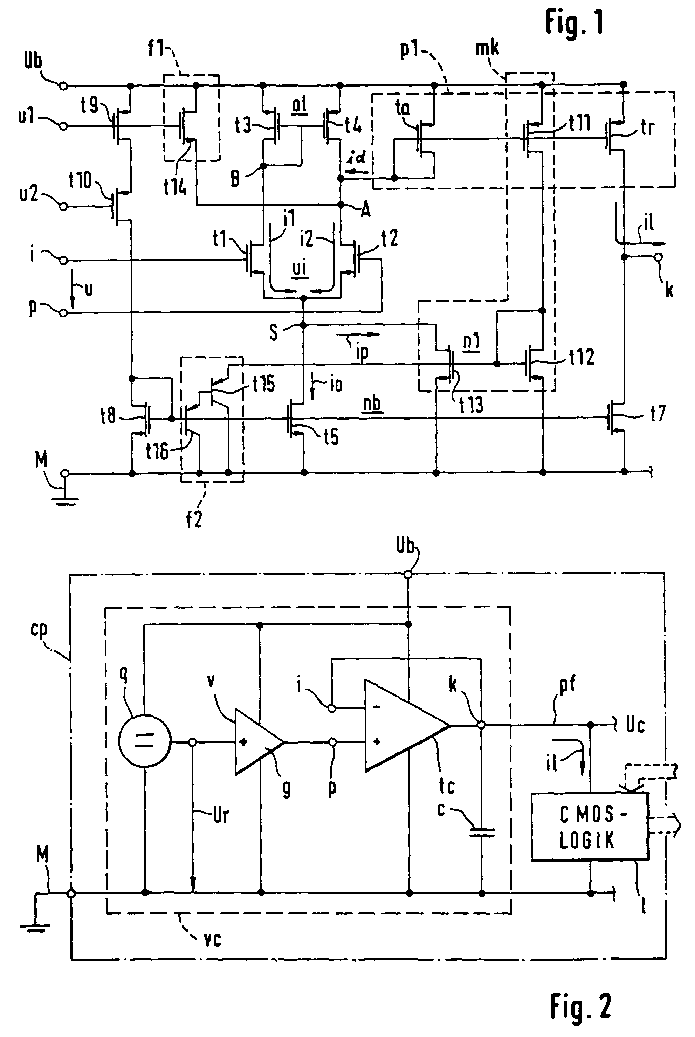

Der in Fig. 1 dargestellte, im wesentlichen aus der oben angegebenen Literaturstelle entnehmbare CMOS-Transkonduktanzverstärker enthält in seinem Eingang einen Spannungs-Stromumsetzer ui aus einem ersten und einem zweiten Transistor t1, t2 vom n-Kanl-Typ. Der Gate-Anschluß des ersten bzw. zweiten Transistors ist mit dem invertierenden bzw. nichtinvertierenden Eingang i, p verbunden, dessen Klemmen die Eingangsspannung u als Differenzspannung zugeführt ist. Die gemeinsam verbundenen Source-Anschlüsse des ersten und zweiten Transistors t1, t2 bilden einen Stromspeisepunkt S, der mit einem Ruhestrom io aus einer n-Kanal-Strombank nb gespeist ist.

Der Drain-Anschluß des zweiten bzw. ersten Transistors t2, t1 ist mit einem ersten bzw. zweiten Schaltungspunkt A, B verbunden. Der dem Stromspeisepunkt S zugeführte Strom wird durch den Spannungs-Stromumsetzer ui in einen ersten und einen zweiten Teilstrom i1, i2 aufgeteilt. Am ersten bzw. zweiten Schaltungspunkt A, B ist der zweite bzw. erste Teilstrom i2, i1 abgreifbar, wobei das Gewichtungsverhältnis von der Eingangsspannung u abhängig ist.

Zwischen dem ersten und zweiten Schaltungspunkt A, B liegt der Ausgang bzw. Eingang einer aktiven Last al aus zwei p-Kanal-Transistoren, nämlich dem dritten bzw. vierten Transistor t3, t4, die einen p-Kanal-Stromspiegel bilden.

Die Zusammenschaltung der Ausgangsströme vom zweiten Transistor t2 und aktiver Last al im ersten Schaltungspunkt A bewirkt eine Differenzbildung des ersten und zweiten Teilstromes i1, i2. Der erste Schaltungspunkt A bildet für den Differenzstrom id den Stromausgang des Spannungs-Stromumsetzers ui.

Mittels eines Auskoppel-Stromspiegels p1 aus p-Kanal-Transistoren wird der Differenzstrom id niederohmig ausgekoppelt. Hierzu liegt ein Auskoppeltransistor ta mit seinem gemeinsamen Gate-Drain-Anschluß am ersten Schaltungspunkt A und definiert so das Potential der gemeinsamen Gate-Verbindungsleitung des Auskoppel-Stromspiegels p1. Der Fußpunkt dieses Stromspiegels p1 ist mit der positiven Versorgungsspannung Ub verbunden. Der Auskoppel-Stromspiegel p1 enthält den Ausgangstransistor tr, einen weiteren Transistor t11, der den Eingang einer Mitkoppelschaltung mk bildet, sowie den Auskoppeltransistor ta.

Der Ruhestrom io, der dem Stromspeisepunkt S zugeführt ist, ist von der n-Kanal-Strombank nb mittels eines fünften Transistors t5 vom n-Kanal-Typ gebildet, dessen Gate an die Gate-Verbindungsleitung der n-Kanal-Strombank nb angeschlossen ist.

Der in Fig. 1 dargestellte CMOS-Transkonduktanzverstärker zeigt in seiner Ausgangsstufe zwar ein komplementäres Transistorpaar tr, t7, deren Source-Drain-Strecken in Serie geschaltet sind, wobei der gemeinsame Drain-Anschluß einen Ausgangsschaltungspunkt k bildet, an dem der Laststrom il abzugreifen ist. Der zweite Ausgangstransistor t7 ist jedoch nur ganz schwach über die n-Kanal-Strombank nb angesteuert, so daß sein konstanter Drain-Source-Strom etwa dem geringen Ruhestrom io des Spannungs-Stromumsetzers ui gleich ist. Zudem ist das W/L-Verhältnis des zweiten Ausgangstransistors t7 im Verhältnis zum ersten Ausgangstransistor tr etwa um den Faktor 1000 kleiner, so daß die Auswirkung auf den Laststrom il bei großen Strömen vernachlässigbar ist.

Über das W/L-Verhältnis des ersten und zweiten Transistors t1, t2, des Ausgangstransistors tr und des Auskoppeltransistors ta sowie über den Ruhestrom io ist die Steilheit des CMOS-Transkonduktanzverstärkers einstellbar. Die Einstellung der Steilheit über diese Maßnahmen ist nach oben jedoch begrenzt. Insbesondere darf der Schaltungspunkt A nur wenig kapazitiv belastet werden, weil andernfalls die Schaltung instabil wird. Ein großes W/L-Verhältnis beim Ausgangstransistor tr wirkt sich über die vergrößerte Gate-Fläche direkt als kapazitive Belastung des Schaltungspunktes A aus.

Da für die vorgesehene Verwendung des CMOS-Transkonduktanzverstärkers in einem "on-Chip"-Spannungsregler lediglich eine Laststromrichtung vorgesehen ist, erübrigt sich eine hohe Stromergiebigkeit beim zweiten Ausgangstransistor t7. Durch ihn soll lediglich ein schwebender Zustand des Ausgangspotentials ohne Last verhindert werden. Es reicht dafür aus, daß der kleine zweite Ausgangstransistor t7 an die Gate-Verbindungsleitung der n-Kanal-Strombank nb mit angeschlossen wird, wodurch über seine Drain-Source-Strecke ein kleiner Konstantstrom, der proportional oder gleich dem Ruhestrom io ist, fließt. Das Potential der gemeinsamen Gate-Verbindungsleitung ist von einem Steuertransistor t8 vom n-Kanal-Typ gesteuert, dessen gemeinsamer Gate-Drain-Anschluß über eine kaskodierte Stromquelle aus der positiven Versorgungsspannung Ub gespeist ist. Der Gate-Anschluß des ersten bzw. zweiten Transistors t9, t10 der kaskodierten Stromquelle liegt an einer ersten bzw. zweiten Vorspannung u1, u2. Die positive Versorgungsspannung Ub bildet auch den Fußpunkt für die aktive Last al und den Auskoppel-Stromspiegel p1.

Da das W/L-Verhältnis des Ausgangstransistors tr im Vergleich zum Auskoppeltransistor ta wegen der kapazitiven Belastung nicht beliebig vergrößert werden kann, wird nach der Erfindung mittels einer Mitkopplungsschaltung mk ein anderer Weg beschritten, um die Steilheit des CMOS-Transkonduktanzverstärkers weiter zu vergrößern. Die Mitkopplungsschaltung mk erzeugt hierzu einen laststromproportionalen Hilfsstrom ip, der dem konstanten Ruhestrom io hinzugefügt wird und daher einen gleitenden Arbeitspunkt des Steuerstromes im Spannungs-Stromumsetzer ui bewirkt. Dabei enthält die Mitkopplungsschaltung mk lediglich einen ersten Mitkoppeltransistor t11 vom p-Kanal-Typ und einen zweiten und dritten Mitkoppeltransistor t12, t13 vom n-Kanal-Typ, die als n-Kanal-Stromspiegel n1 zusammengeschaltet sind. Der erste Mitkoppeltransistor t11 ist Teil des Auskoppel-Stromspiegels p1, wobei sein Drain-Anschluß mit dem Eingang des n-Kanal-Stromspiegels n1 verbunden ist. Dessen Ausgang wird vom Drain-Anschluß des dritten Mitkoppeltransistors t13 gebildet und ist mit dem Stromspeisepunkt S verbunden. Der Drain-Anschluß des dritten Mitkoppeltransistors stellt für den laststromproportionalen Hilfsstrom ip eine hochohmige Stromsenke dar. Der Fußpunkt des n-Kanal-Stromspiegels n1 ist die negative Versorgungsspannung, die in der Regel auch der Masseanschluß M ist.

Der wesentliche Vorteil des Transkonduktanzverstärkers nach Fig. 1 besteht nun darin, daß trotz der hohen Gesamtsteilheit der Ruhestrom des Ausgangstransistors tr vernachlässigbar ist, insbesondere wenn kein Laststrom il fließt. Dies reduziert die Gesamtstromaufnahme und begünstigt dadurch einen Batteriebetrieb. Dies wird durch die Parallelschaltung der aktiven Last al und der niederohmigen Diodenstrecke des Auskoppeltransistor ta wie folgt erreicht: - Bei einer Eingangsspannung u von 0 Volt sind die beiden Teilströme i1, i2 einander gleich. Daher ist auch der Ausgangsstrom der aktiven Last al am vierten Transistor t4 gleich groß wie der Drain-Strom des zweiten Transistors t2, so daß die Stromdifferenz am ersten Schaltungspunkt A zu null wird. Für die Ansteuerung des Auskoppel-Stromspiegels pl bleibt somit kein Strom übrig, wodurch der Ausgangstransistor tr bis auf den kleinen Konstantstrom des zweiten Ausgangstransistors t7 stromlos wird. Damit ist die niedere Stromaufnahme des CMOS-Transkonduktanzverstärkers bei geringem oder vernachlässigbaren Laststrom i1 gewährleistet.

Die Ergiebigkeit des Ausgangstransistors tr umfaßt beispielsweise einen Bereich von 2 Mikroampere im Ruhezustand bis 5 Milliampere im Betriebszustand. Die Gesamtstromaufnahme des CMOS-Transkonduktanzverstärkers im Ruhezustand beträgt dabei ca. 5 Mikroampere - dies ist die Stromaufnahme der n-Kanal-Strombank nb.

Damit im Betriebszustand der maximale Laststrom il bei einem kurzzeitigen Kurzschluß auf ca. 30 Milliampere begrenzt wird, ist eine Strombegrenzungseinrichtung vorgesehen, die aus einer ersten und zweiten Strombegrenzungsschaltung f1, f2 besteht. Die erste Strombegrenzungsschaltung f1 verhindert mittels eines als Source-Folger geschalteten n-Kanal-Transistors t14 das zu tiefe Absinken des ersten Schaltungspunktes A. Der Gate- bzw. Drain-Anschluß dieses Transistors t14 ist mit der ersten Vorspannung ul bzw. mit der positiven Versorgungsspannung Ub verbunden. Die zweite Strombegrenzungsschaltung f2 besteht aus einer Darlington-Schaltung von zwei Substrat-pnp-Transistoren t15, t16, wobei der Darlington-Emitter des Transistors t15 mit dem gemeinsamen Gate-Anschluß des n-Kanal-Stromspiegels nl verbunden ist. Der Darlington-Basis-Anschluß des Transistors t16 ist an die gemeinsamen Gate-Verbindungsleitung der n-Kanal-Strombank nb angeschlossen. Die in Fig. 1 dargestellte Strombegrenzung erfordert nur sehr wenige zusätzliche Schaltungsteile - eine effektivere, gegebenenfalls aufwendigere Strombegrenzung liegt im Rahmen fachmännischen Handelns.

Bei einer Verwendung des CMOS-Transkonduktanzverstärkers nach Fig. 1 in einer Schaltungsanordnung nach Fig. 2 ist es gegebenenfalls erforderlich, daß ein Teil der Transistoren mit einer höheren Drain-Source-Abbruchspannung als bei üblichen CMOS-Transistoren ausgelegt wird. Dies ist der Fall, wenn als positive Versorgungsspannung Ub eine Spannung verwendet wird, die größer als die übliche CMOS-Versorgungsspannung ist, die typisch im Bereich von 5 V liegt. Bei einer Anwendung im Kraftfahrzeug kann z.B. die Bordspannung bis über 24 V ansteigen. Diese Spannung muß dann von den meisten Transistoren des CMOS-Transkonduktanzverstärkers noch sicher beherrscht werden können. Es sind dies insbesondere die Transistoren t1, t2, t10, t11 und tr in Fig. 1. Aus Sicherheits- oder Symmetriegründen können weitere Transistoren, z.B. der Auskoppeltransistor ta und der zweite Ausgangstransistor t7, ebenfalls in der hohen Spannungsfestigkeit ausgelegt sein. Die einzelnen Schaltungsblöcke der logischen Signalverarbeitung in der CMOS-Schaltung 1 können durch die "on-Chip"-Spannungsregelung einer üblichen Zellenbibliothek entnommen werden, wobei die einzelnen Zellen in ihrer Auslegung für eine vorgegebene Schaltungstechnologie und eine vorgegebene Versorgungsspannung, die etwa der geregelten Versorgungsspannung Uc gleich ist, optimiert sind.

Das Schaltbild von Fig 1 geht von einer n-Wannen-Technik aus, deren Wannenanschluß mit der positiven Versorgungsspannung Ub verbunden ist. Als selbstverständliches Äquivalent ist hierzu die Ausführung in p-Wannen-Technik anzusehen.

In Fig. 2 ist schematisch der Spannungsregler nach der Erfindung mit dem CMOS-Transkonduktanzverstärkers in einem "on-Chip"-Spannungsregler dargestellt. Der Transkonduktanzverstärker tc dient als Längsregler innerhalb eines Spannungsreglers vc, der zusammen mit der logischen CMOS-Schaltung 1 auf einer Halbleiterkristallfläche cp monolithisch integriert ist. Der Spannungsregler vc enthält eine Referenzspannungsquelle q, die eine Referenzspannung Ur von beispielsweise 2,5 V erzeugt. Da diese Referenzspannung nicht belastbar ist, wird ihr ein Elektrometerverstärker v mit dem Verstärkungsfaktor g nachgeschaltet. Mit einem Verstärkungsfaktor g = 2 liefert der Ausgang des Elektrometerverstärkers v eine Spannung von etwa 5 V, die dem nichtinvertierenden Eingang p des Transkonduktanzverstärkers zugeführt ist. Dessen Ausgangsschaltungspunkt k ist mit dem invertierenden Eingang i verbunden, so daß die Spannung des Ausgangs-Schaltungspunktes k gleich der Ausgangsspannung des Elektrometerverstärkers v ist. Der Transkonduktanzverstärker tc arbeitet als Impedanzwandler. Der Ausgangsschaltungspunkt k, der die geregelte Versorgungsspannung Uc von 5 V liefert, ist mit der positiven Versorgungsleitung pf der CMOS-Schaltung l verbunden. Die Referenzspannungsquelle q und der Elektrometerverstärker v sind direkt von der positiven Versorgungsspannung Ub gespeist, da diese Spannung zwar ungeregelt, aber relativ ruhig ist.

Die sehr steilen Stromspitzen, die bei der Umschaltung der einzelnen Gatter in der CMOS-Schaltung l zwischen der positiven Versorgungsleitung pf und dem Masseanschluß M entstehen, werden durch einen auf dem Chip mitintegrierten Kondensator c abgeblockt, dessen Kapazität beispielsweise 1 Nanofarad aufweist. Die schnelle Nachladung des Kondensators c wird durch die hohe Grenzfrequenz des Transkonduktanzverstärker begünstigt, die etwa bei 1 Megahertz liegt. Hierbei erweist sich von Vorteil, daß der Transkonduktanzverstärker tc trotz voller Gegenkopplung keine interne Frequenzkompensation wie der Operationsverstärker benötigt, die ihn langsam machen wurde. Seine Stabilität wird durch den Anschluß des mitintegrierten Kondensators c am Ausgangsschaltungspunkt k erreicht, wobei der Kondensator c gleichzeitig der Pufferung der steilen Stromspitzen dient. Durch diese doppelte Wirkung des mitintegrierten Kondensators c erübrigen sich externe Siebmittel und die dafür erforderlichen externen Anschlußkontakte bei der gesamten Schaltungsanordnung nach Fig. 2. Dieser zusätzliche Vorteil kommt insbesondere der Anwendung im Konsum- bzw. Kraftfahrzeugbereich entgegen.

## Patentansprüche

1. Spannungsregler (vc), der einen CMOS-Transkonduktanzverstärker (tc) mit gleitendem Arbeitspunkt enthält, mit
- einem Spannungs-Stromumsetzer (ui), der einen Differenzeingang für eine Eingangsspannung (u) aufweist,
- einem Auskoppel-Stromspiegel (p1) als Ausgang, dessen Steuereingang mit dem Stromausgang des Spannungs-Stromumsetzers (ui) gekoppelt ist, wobei
- der hochohmige Stromausgang des Auskoppel-Stromspiegels (p1) mit einem Ausgangsschaltpunkt (k) verbunden ist, an dem der Ausgangsstrom des Transkonduktanzverstärkers, ein Laststrom (il), abgreifbar ist, und
- einer Mitkopplungsschaltung (mk), die einen laststromproportionalen Hilfsstrom (ip) erzeugt, der zusammen mit einem konstanten Ruhestrom (io) einem Stromspeisepunkt (S) des Spannungs-Stromumsetzers (ui) zugeführt ist, wobei
- der Spannungs-Stromumsetzer (ui) als Stromausgang eine aktive Last (a1) enthält, die aus einem ersten und einem zweiten Teilstrom (i1, i2), deren Gewichtungsverhältnis von der Eingangsspannung (u) abhängig ist, einem Differenzstrom (id) bildet, der an einem ersten Schaltungspunkt (A) abgreifbar ist,
- am ersten Schaltungspunkt (A) zur Auskopplung des Differenzstromes (id) der niederohmige Eingang des Auskoppel-Stromspiegels (p1) angeschlossen ist und
- der hochohmige Ausgang des Auskoppel-Stromspiegels (p1) durch den hochohmigen Stromausgang eines Ausgangstransistors (tr) gebildet ist,
gekennzeichnet durch folgende Merkmale:
- eine signalverarbeitende Schaltung (l) in CMOS-Technik ist zusammen mit dem Spannungsregler (vc) in einem Halbleiterkristall ausgebildet,
- der Spannungsregler (vc), der als Längsregler aus einer ungeregelten Versorgungsspannung (Ub) eine geregelte Versorgungsspannung (Uc) ohne externe Siebmittel erzeugt, enthält folgende Schaltungseinheiten:
- eine Referenzspannungsquelle (q) mit einem nachgeschalteten Elektrometerverstärker (v),
- den Transkonduktanzverstärker (tc), dessen nichtinvertierender Eingang (p) mit dem Ausgang des Elektrometerverstärkers (v) und dessen invertierender Eingang (i) mit einem Ausgangsschaltpunkt t (k) des Transkonduktanzverstärkers (tc) verbunden ist, und
- einen mitintegrierten Kondensator (c), dessen erster Anschluß mit dem Ausgangsschaltpunkt (k) und dessen zweiter Anschluß mit einem festen Bezugspotential (M) verbunden ist, wobei der mitintegrierte Kondensator (c) sowohl der Stabilisierung des Transkonduktanzverstärkers (tc) als auch der Pufferung der Umschalt-Stromspitzen der signalverarbeitenden Schaltung (1) dient.

2. Spannungsregler (vc) nach Anspruch 1, dadurch gekennzeichnet, daß eine Strombegrenzungseinrichtung (f1, f2) den Laststrom (il) auf einen maximalen Wert begrenzt.

3. Spannungsregler (vc) nach Anspruch 1, dadurch gekennzeichnet, daß mindestens ein erster und ein zweiter Transistor (t1, t2) des Spannungs-Stromumsetzers (ui), die in einer Differenzschaltung über einen gemeinsamen, einen Stromspeisepunkt (S) bildenden Source-Anschluß zusammengeschaltet sind, der Ausgangstransistor (tr) und ein erster Mitkoppeltransistor (t11) in ihren Abmessungen so ausgelegt sind, daß ihre Source-Drain-Abbruchspannungen durch den Betrieb an der ungeregelten Versorgungsspannung (Ub) nicht überschritten werden, wobei der erste und zweite Transistor (t1, t2) vom n-Kanal-Typ und der Ausgangstransistor (tr) und der erste Mitkoppeltransistor (t11) vom p-Kanal-Typ sind.

4. Spannungsregler (vc) nach Anspruch 1, gekennzeichnet durch folgende Merkmale:
- die signalverarbeitende Schaltung (1) enthält eine digitale Schaltung, die aus einer Vielzahl von logischen Zellen aufgebaut ist, und
- die einzelnen logischen Zellen sind in ihrer Auslegung für eine vorgegebene Schaltungstechnologie und eine vorgegebene Versorgungsspannung, die etwa der geregelten Versorgungsspannung (Uc) gleich ist, optimiert.

## Claims

1. A voltage regulator (vc) comprising a CMOS transconductance amplifier (tc) with floating operating point, with
- a voltage-to-current converter (ui) having a differential input for an input voltage (u),
- an output current mirror (p1) having its control input coupled to the current output of the voltage-to-current converter (ui),
-- the high-impedance current output of the output current mirror (p1) being connected to an output node (k) from which the output current of the transconductance amplifier, a load current (il), is available, and
- a positive-feedback circuit (mk) generating an auxiliary current (ip) which is proportional to the load current and is supplied, together with a constant quiescent current (io), to a current feed point (S) of the voltage-to-current converter (ui);
-- the voltage-to-current converter (ui) comprising, as its current-output stage, an active load (al) which forms from a first and a second current (i1, i2), whose weighting ratio is dependent on the input voltage (u), a differential current (id) which is available from a first junction point (A);
-- the low-impedance input of the output current mirror (p1) being connected to the first junction point (A) for coupling out the differential current (id),
-- the high-impedance output of the output current mirror (p1) being formed by the high-impedance current output of an output transistor (tr),
characterized by the following features:
- A signal-processing CMOS circuit (l) and a voltage regulator (vc) are integrated on a single semiconductor chip;
- the voltage regulator (vc), which, as a series regulator, generates a regulated supply voltage (Uc) from an unregulated supply voltage (Ub) without external filter means, contains the following subcircuits:
-- a voltage-reference source (q) followed by an electrometer amplifier (v),
-- the transconductance amplifier (tc), whose noninverting input (p) is connected to the output of the electrometer amplifier (v) and whose inverting input (i) is connected to an output node (k) of the transconductance amplifier (tc), and
-- an on-chip capacitor (c) having a first terminal connected to the output node (k) and a second terminal tied to a fixed reference potential (M), the on-chip capacitor (c) serving both to stabilize the transconductance amplifier (tc) and to buffer the the switching transient current spikes of the signal-processing circuit (1).

2. A voltage regulator (vc) as claimed in claim 1, characterized in that a current-limiting facility (f1, f2) limits the load current (il) to a maximum value.

3. A voltage regulator (vc) as claimed in claim 1, characterized in that at least a first transistor (t1) and a second transistor (t2) of the voltage-to-current converter (ui) which are connected together via a common source terminal forming a current feed point (S) to form a differential circuit, the output transistor (tr), and a first positive-feedback transistor (t11) are so designed that their source-drain breakdown voltages are not exceeded by operation at the unregulated supply voltage (Ub), the first and second transistors (t1, t2) being of the n-channel type and the output transistor (tr) and the first positive-feedback transistor (t11) being of the p-channel type.

4. A voltage regulator (vc) as claimed in claim 1, characterized by the following features:
- The signal-processing circuit (l) contains a digital circuit constructed from a plurality of logic cells, and
- the design of the individual logic cells is optimized for a specified circuit technology and a specified supply voltage which is approximately equal to the regulated supply voltage (Uc).

## Revendications

1. Régulateur de tension (vc), qui contient un amplificateur CMOS à transconductance à point de fonctionnement glissant, comprenant :
- un convertisseur tension-courant (ui), qui comporte une entrée différentielle pour une tension d'entrée (u),
- un miroir de courant de découplage (p1), servant de sortie, dont l'entrée de commande est couplée à la sortie de courant du convertisseur tension-courant (ui), tandis que
- la sortie de courant de valeur ohmique élevée du miroir de courant de découplage (p1) est reliée à un point de borne de sortie (k), sur lequel le courant de sortie de l'amplificateur à transconductance, un courant de charge (i1), peut être prélevé, et
- un circuit de rétroaction (mk), qui produit un courant auxiliaire (ip) proportionnel au courant de charge, qui est appliqué, avec un courant de repos (io) constant, sur un point d'alimentation de courant (S) du convertisseur tension-courant (ui), tandis que
- le convertisseur tension-courant (ui), servant de sortie de courant, contient une charge active (al) qui, à partir d'un premier et d'un second courants partiels (i1, i2) dont le rapport de pondération dépend de la tension d'entrée (u), constitue un courant différentiel (id) qui peut être prélevé sur un premier point du circuit (A),
- l'entrée de faible valeur ohmique du miroir de courant de découplage (p1) est raccordée au premier point du circuit (A) en vue du découplage du courant différentiel (id) et
- la sortie de valeur ohmique élevée du miroir de courant de découplage (p1) est constituée par la sortie de courant de valeur ohmique élevée d'un transistor de sortie (tr),
caractérisé par les particularités suivantes :
- un circuit de traitement de signaux (1) en technique CMOS est réalisé avec le régulateur de tension (vc) dans un cristal de semi-conducteur,
- le régulateur de tension (vc), qui, en tant que régulateur serie, produit une tension d'alimentation (Uc) soumise à une régulation, à partir d'une tension d'alimentation (Ub) qui n'est pas soumise à une régulation et sans moyens extérieurs de filtrage, contient les unités de circuit suivantes :
- une source de tension de référence (q) comportant un amplificateur électrométrique (v) connecté en aval,
- l'amplificateur à transconductance (tc) dont l'entrée non inverseuse (p) est reliée à la sortie de l'amplificateur électrométrique (v) et dont l'entrée inverseuse (i) est reliée à un point de borne de sortie (k) de l'amplificateur à transconductance (tc) et
- un condensateur (c), intégré au circuit, dont une première borne est reliée au point de borne de sortie (k) et dont une deuxième borne est reliée à un potentiel de référence (M) fixe, le condensateur (c) intégré au circuit servant aussi bien à la stabilisation de l'amplificateur à transconductance (tc) qu'à l'amortissement des pointes de courant de commutation du circuit de traitement de signaux (1).

2. Régulateur de tension (vc) selon la revendication 1, caractérisé en ce qu'un dispositif de limitation de courant (f1, f2) limite le courant de charge (il) à une valeur maximale.

3. Régulateur de tension (vc) selon la revendication 1, caractérisé en ce qu'au moins un premier et un second transistors (t1, t2) du convertisseur tension-courant (ui), qui sont connectés ensemble dans un circuit différentiel au moyen d'une borne de source commune constituant un point d'alimentation de courant (S), le transistor de sortie (tr) et un premier transistor de rétroaction (t11) sont conçus en ce qui concerne leurs paramètres de façon que leur tension de claquage source-drain ne soit pas dépassée du fait du fonctionnement sur la tension d'alimentation (Ub) non soumise à une régulation, le premier et le second transistors (t1, t2) étant du type à canal N et le transistor de sortie (tr) et le premier transistor de rétroaction (t11) étant du type à canal P.

4. Régulateur de tension (vc) selon la revendication 1, caractérisé par les particularités suivantes:
- le circuit de traitement de signaux (1) contient un circuit numérique, qui est assemblé à partir de multiples cellules logiques, et
- les différentes cellules logiques sont rendues optimales, en ce qui concerne leur conception, pour une technique de circuit préfixée et une tension d'alimentation préfixée qui est approximativement égale à la tension d'alimentation (uc) soumise à une régulation.
